(19) Europäisches Patentamt
European Patent Office
Office européen des brevets

(11) **EP 3 038 225 A2**

(12) **EUROPEAN PATENT APPLICATION**

(43) Date of publication:
**29.06.2016 Bulletin 2016/26**

(51) Int Cl.:
*H02H 7/18* (2006.01)    *G01R 31/36* (2006.01)

(21) Application number: **15199880.4**

(22) Date of filing: **14.12.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **25.12.2014   CN 201410828976**

(71) Applicant: **Xiaomi Inc.
Beijing 100085 (CN)**

(72) Inventors:
• **SUN, Wei
  100085 BEIJING (CN)**
• **SUN, Changyu
  100085 BEIJING (CN)**
• **WANG, Xiangdong
  100085 BEIJING (CN)**

(74) Representative: **Underwood, Nicolas Patrick et al
Cabinet Beau de Loménie
158, rue de l'Université
75340 Paris Cedex 07 (FR)**

(54) **VOLTAGE DETECTION APPARATUS, BATTERY AND VOLTAGE DETECTION METHOD**

(57)    The present invention relates to a voltage detection apparatus, a battery and a voltage detection method. The voltage detection apparatus includes: a voltage detection module (110) and a circuit line (120); in which, a segment of the circuit line is configured as a line resistor (121), and detecting terminals (111) of the voltage detection module are connected to terminals of the line resistor via measuring lines (112) respectively. The voltage detection apparatus provided by embodiments of the present invention, by configuring the segment of the circuit line as the line resistor, just enables the voltage detection module to detect the voltage over the line resistor. Since the line resistor itself is a part of the circuit line, the resistance thereof will not change greatly with changes of voltage and temperature, so the line resistor has a good stability and thus the voltage detection is accurate.

Fig. 3

**Description**

**TECHNICAL FIELD**

The present invention relates to the field of circuit technology, and more particularly, to a voltage detection method, a battery and a voltage detection method.

**BACKGROUND**

A power source protection circuit detects a voltage over a power source path, thereby determining whether to cut off the power source path according to a detection result, so as to protect the power source. An example of power protection circuit in a battery, in the related art, consists in an integrated protection circuit in the power source protection circuit connected to terminals of a metal-oxide-semiconductor field-effect transistor (MOSFET) via measuring lines, which obtains a battery voltage by detecting a voltage over the terminals of the MOSFET, so as to cut off the power source path between the power source protection circuit and a battery cell if the battery voltage is abnormal.

However, due to the MOSFET's own characteristics, in charging and discharging processes, a resistance of the MOSFET will change greatly along with changes of voltage and temperature, so that the detected voltage is not accurate enough, thus resulting in a poor protection of the power source path.

**SUMMARY**

Accordingly, embodiments of the present invention provide a voltage detection apparatus, a battery and a voltage detection method.

According to a first aspect of embodiments of the present invention, there is provided a voltage detection apparatus, including: a voltage detection module and a circuit line;

a segment of the circuit line is configured as a line resistor, and detecting terminals of the voltage detection module are connected to terminals of the line resistor via measuring lines respectively.

According to a particular embodiment, the voltage detection module includes: an integrated protection circuit, or a voltammeter.

According to a particular embodiment, if the voltage detection module is the integrated protection circuit, the voltage detection apparatus further includes an on-off control line and a metal-oxide-semiconductor field-effect transistor, and the integrated protection circuit is connected with the metal-oxide-semiconductor field-effect transistor via the on-off control line;

a first terminal of the circuit line is connected with the metal-oxide-semiconductor field-effect transistor and a second terminal of the circuit line is connected with a battery cell.

According to a particular embodiment, if the integrated protection circuit detects that a voltage over the line resistor is outside a predetermined voltage range, the integrated protection circuit is disconnected from the metal-oxide-semiconductor field-effect transistor via the on-off control line.

According to a particular embodiment, a length of the line resistor satisfies a formula of

$$L = \frac{R \times S}{\rho}$$, where, L represents the length of the line resistor, R represents a resistance of the line resistor, S represents a sectional area of the line resistor, and $\rho$ represents a resistivity of the line resistor.

According to a particular embodiment, a predetermined resistance of the line resistor is 10 milliohms.

According to a second aspect of embodiments of the present invention, there is provided a battery, including: a power source protection circuit and a battery cell; in which

the power source protection circuit includes an integrated protection circuit, a metal-oxide-semiconductor field-effect transistor connected with the integrated protection circuit via an on-off control line and a circuit line having a first terminal connected with the metal-oxide-semiconductor field-effect transistor and a second terminal connected with the battery cell;

in which, a segment of the circuit line is configured as a line resistor, and detecting terminals of the integrated protection circuit are connected to terminals of the line resistor via measuring lines respectively.

According to a particular embodiment, a length of the line resistor satisfies a formula of

$$L = \frac{R \times S}{\rho}$$, where, L represents the length of the line resistor, R represents a resistance of the line resistor, S represents a sectional area of the line resistor, and $\rho$ represents a resistivity of the line resistor.

According to a particular embodiment, a predetermined resistance of the line resistor is 10 milliohms.

According to a third aspect of embodiments of the present invention, there is provided a voltage detection method, applied a battery described above and including:

detecting by the integrated protection circuit a battery voltage over the line resistor with the measuring lines; determining whether the battery voltage is within a predetermined voltage range; disconnecting the integrated protection circuit from the metal-oxide-semiconductor field-effect transistor by the on-off control line if the battery voltage is outside the predetermined voltage range.

The technology solutions provided by embodiments of the present invention have following advantageous effects.

The voltage detection apparatus provided by embodiments of the present invention, by configuring the segment of the circuit line as the line resistor, just enables the voltage detection module to detect the voltage over the line resistor. Since the line resistor itself is a part of the circuit line, the resistance thereof will not change greatly with changes of voltage and temperature, so the line resistor has a good stability and thus the voltage detection is accurate.

The voltage detection module in the voltage detection apparatus provided by embodiments of the present invention may be configured as the integrated protection circuit in the battery, or the voltammeter specifically configured to obtain a current value by detecting voltage, and thus the voltage detection module can be used in various voltage detection scenes.

If the voltage detection module in the voltage detection apparatus provided by embodiments of the present invention is the integrated protection circuit, the integrated protection circuit is connected with the metal-oxide-semiconductor field-effect transistor via the on-off control line, and thus the on-off of the metal-oxide-semiconductor field-effect transistor may be controlled by detecting the voltage over the line resistor so as to protect the power source path well.

In the present invention, the length of the line resistor may be determined according to the predetermined resistance of the line resistor, the sectional area of the line resistor and the resistivity of the line resistor with the predetermined formula, and in an actual application, the length of the line resistor may be corrected to obtain an appropriate one, thus satisfying the requirement of the voltage detection and improving a degree of accuracy of the voltage detection.

The battery and the voltage detection method applied in the battery, provided by embodiments of the present invention, by detecting the line resistor in the circuit line with the power source protection circuit, may obtain an accurate voltage value and control the on-off of the metal-oxide-semiconductor field-effect transistor by the voltage value, such that the battery cell can be protected well in charging and discharging processes of the battery cell.

It is to be understood that both the foregoing general description and the following detailed description are exemplary and explanatory only and are not restrictive of the invention, as claimed.

## BRIEF DESCRIPTION OF THE DRAWINGS

The accompanying drawings, which are incorporated in and constitute a part of this specification, illustrate embodiments consistent with the invention and, together with the description, serve to explain the principles of the invention.

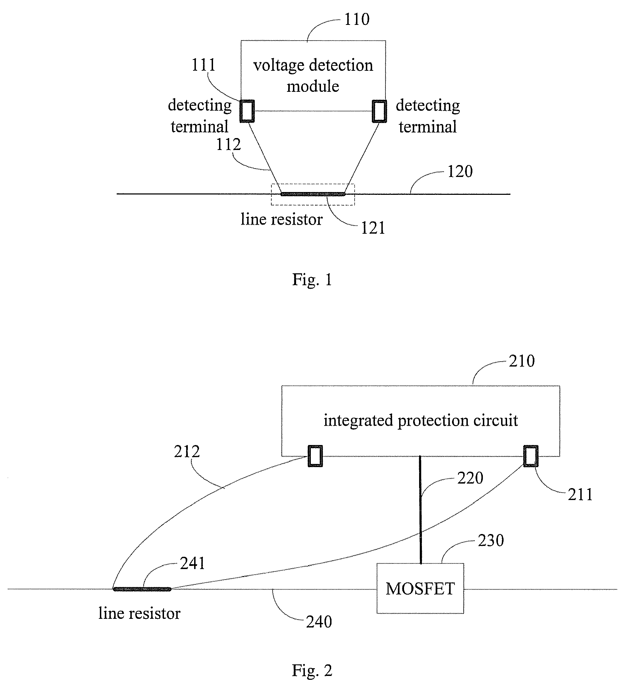

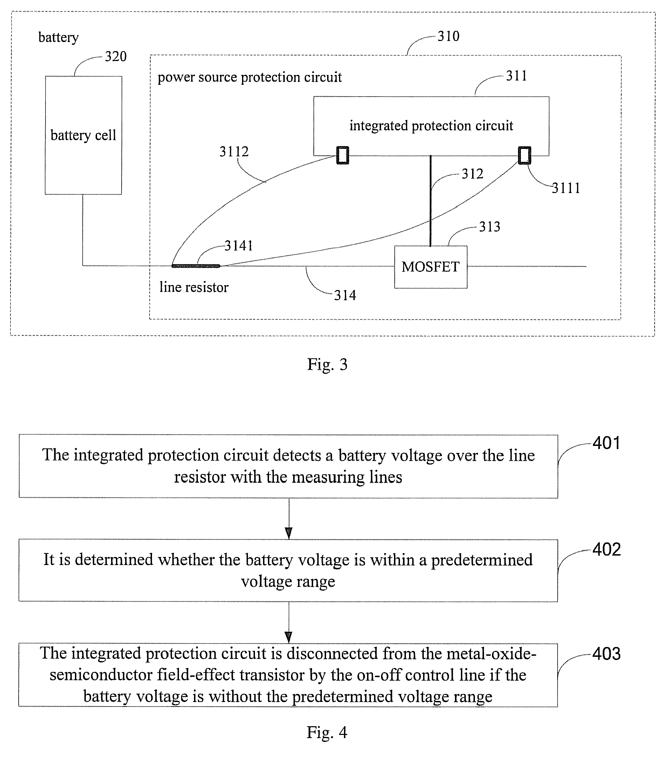

Fig. 1 is a schematic diagram showing a voltage detection apparatus according to an exemplary embodiment; Fig. 2 is a schematic diagram showing another voltage detection apparatus according to an exemplary embodiment; Fig. 3 is a schematic diagram showing a battery according to an exemplary embodiment; Fig. 4 is a flow chart showing a voltage detecting method according to an exemplary embodiment.

## DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

Terms used in embodiments of the present invention are only intended for a description of a particular embodiment, but not for limitation of the present invention. "A/an", "the" and "this" in a singular form used in the present invention and the attracted claims are also intended to include a plural form thereof, unless other meanings are indicated in the context clearly. It also should be understood that, the term "and/or" used herein means and includes any or all possible combinations of one or more listed items associated with each other.

It should be noted that, although terms such as first, second and third are used herein to describe various information, these information is not limited to these terms. These terms are only used to distinguish the information of a same type from each other. For example, the first information may also be called as the second information and similarly the second information may also be called as the first information without departing from the scope of the present invention. Depending on the context, the word "if" used herein may be interpreted as "at the moment that" or "when" or "in response to determining".

As shown in Fig. 1, in which Fig. 1 is a schematic diagram showing a voltage detection apparatus according to an exemplary embodiment, the voltage detection apparatus includes: a voltage detection module 110 and a circuit line 120.

In the embodiment, when the voltage is detected, it is not needed to detect a special circuit element, such as a detection resistor disposed specially or a metal-oxide-semiconductor field-effect transistor (MOSFET) disposed in the detection apparatus, while a segment of the circuit line 120 is configured as a line resistor 121, and detecting terminals 111 of the voltage detection module 110 are connected with terminals of the line resistor 121 via measuring lines 112 respectively. Therefore, it is just needed for the voltage detection module 110 to detect a voltage over the line resistor 121. Since the line resistor 121 itself is a part of the circuit line 121, a resistance thereof will not change greatly with changes of voltage and temperature, so the line resistor 121 has a good stability, and thus the voltage detection is accurate and a detection precision thereof is high. It should be noted that, the line resistor 121 in Fig. 1 is represented by a bold line, but in an actual application, a thickness and width of the line resistor 121 are same with those of other portions of the circuit line 120, and thus the line resistor 121 represented by the bold line in Fig. 1 is only intended for clear examples, but not used to limit an actual shape of the line resistor 121.

In the embodiment, before the segment of the circuit line 120 is configured as the line resistor 121, it is needed to predetermine a length of the line resistor. When it is to determine the length of the line resistor, a following formula may be adopted:

$$L = \frac{R \times S}{\rho},$$ where, L represents the length of the line resistor, R represents a resistance of the line resistor, of which a predetermined value is 10mΩ (milliohm), S represents a sectional area of the line resistor, which also may be determined after the circuit line 120 is determined, and $\rho$ represents a resistivity of the line resistor, which may be determined when the material of the circuit line 120 is determined, since the resistivity is a physical quantity representing a resistance property of material. According to the above determined parameters, a theoretical value of L may be calculated initially, and an actual length of the line resistor is further corrected based on the theoretical value of L. During the correcting, it may be detected whether an actual value of the line resistor is 10mΩ when L is the theoretical value. If the actual value of the line resistor is less than 10mΩ, the length of the line resistor may be increased until the actual value of the line resistor reaches 10mΩ, and then a corresponding length of the line resistor is determined as an actual value of L. With reference to the actual valve of L, the measuring lines 112 of the voltage detection module 110 are connected to the terminals of the line resistor 121 respectively.

In an embodiment, the voltage detection module 110 may be an integrated protection circuit in the battery, and the integrated protection circuit may be connected with the MOSFET via an on-off control line. The circuit line 120 has a first terminal connected with the MOSFET and a second terminal connected with a battery cell. When detecting that the voltage over the line resistor is outside a predetermined voltage range, the integrated protection circuit disconnects from the MOSFET via the on-off control line, and thus the power source path can be protected well by controlling an on-off of the MOSFET.

In another embodiment, the voltage detection module may be a voltammeter configured to detect an electric quantity of battery. The voltammeter is a functional appliance that detects an increase or a decrease of a accumulated electric quantity of the battery, and is configured to determine a remained electric quantity of a rechargeable battery and how long the battery can further continue supplying power in a particular operation condition, and is capable of estimating the electric quantity of the battery accurately. In the embodiment, the voltammeter may obtain a voltage value by detecting the voltage over the line resistor and calculate a current value according to the voltage value and the resistance of the line resistor so as to measure the current accurately.

As shown in Fig. 2, in which Fig. 2 is a schematic diagram showing another voltage detection apparatus according to an exemplary embodiment, the voltage detection apparatus may be specifically applied to a battery and includes: an integrated protection circuit 210, an on-off control line 220, a metal-oxide-semiconductor field-effect transistor MOSFET 230 and a circuit line 240.

The integrated protection circuit 210 is connected with the MOSFET 230 via the on-off control line 220, and the circuit 240 has a first terminal connected with the MOSFET 230 and a second terminal connected with a battery cell. In the embodiment, a segment of the circuit line 240 is configured as a line resistor 241, and detecting terminals 211 of the integrated protection circuit 210 are connected to terminals of the line resistor 241 via measuring lines 212 respectively. Therefore, a battery voltage can be obtained by the integrated protection circuit 210 detecting a voltage over the line resistor 241. Since the line resistor 241 itself is a part of the circuit line 240, a resistance thereof will not change greatly with changes of voltage and temperature, so the line resistor 241 has a good stability, and thus the voltage detection is accurate and a detection precision thereof is high. It should be noted that, the line resistor 241 in Fig. 2 is represented by a bold line, but in an actual application, a thickness and width of the line resistor 241 are same with those of other portions of the circuit line 240, and thus the line resistor 241 represented by the bold line in Fig. 2 is only intended for clear examples, but not used to limit an actual shape of the line resistor 241.

In the embodiment, the integrated protection circuit 210 is a hardware circuit. When the measuring lines 212 of the integrated protection circuit 210 are connected to sides of the line resistor 241, the voltage over the line resistor 241 can be measured in real time so as to obtain a circuit voltage. When detecting that the voltage over the line resistor 241 is outside a predetermined voltage range, the integrated protection circuit 210 disconnects from the MOSFET 230 via the on-off control line 220. Therefore, in the embodiment, the on-off of the MOSFET can be controlled by measuring the voltage over the line resistor 241, so as to protect the power source path well.

In addition, Fig. 2 only shows one MOSFET exemplarily. In the actual application, when the integrated protection circuit controls the on-off of the MOSFET, there may be two MOSFETs in the circuit and two measuring lines of the integrated protection circuit are connected with two sides of the two MOSFETs respectively. In the embodiment, how a length of the line resistor is determined is consistent with the associated previous description in Fig.1 and is omitted herein.

As shown in Fig. 3, Fig. 3 is a schematic diagram showing a battery according to an exemplary embodiment.

In the embodiment, the battery generally refers to a rechargeable battery having charging and discharging functions. During a usage of the rechargeable battery, an over charging, an over discharging or an over current may affect a working life and function of the battery, and thus it is needed to detect a voltage of an interior of the battery so as to protect the battery from damage. The battery embodied in the embodiment includes: a power source protection circuit 310 and a battery cell 320. The power source protection circuit 310 is configured to detect the voltage of the interior of the battery, and the battery cell 320 is a capacity source of the battery and configured to store energy. In order to protect the battery cell 320, the power source protection circuit 310 measures a battery voltage and a battery current, and thus the power source protection circuit 310 can disconnect from the battery cell 320 to protect the battery when the voltage or current is abnormal.

In the embodiment, the power source protection circuit 310 further includes: an integrated protection circuit 311, a MOSFET 313 connected with the integrated protection circuit 311 via an on-off control line 312 and a circuit line 314 having a first terminal connected with the MOSFET313 and a second terminal connected with the battery cell 320. A segment of the circuit line 314 is configured as a line resistor 3141, and detecting terminals 3111 of the integrated protection circuit 311 are connected to terminals of the line resistor 3141 via measuring lines 3112 respectively. The MOSFET 313 is controlled by the integrated protection circuit 311, and when the integrated protection circuit 311 detects that the voltage or current is abnormal, the integrated protection circuit 311 is connected with or disconnected from the battery cell by controlling the on-off of the MOSFET 313.

When the power source protection circuit 310 detects the battery voltage in the embodiment, a process thereof is consistent with that of the voltage detection apparatus in Fig. 2 and is omitted herein.

Thus it can be seen from above embodiments, the battery provided by the embodiment obtains an accurate voltage value by measuring the line resistor in the circuit line with the power source protection circuit and controls the on-off of the MOSFET according to the voltage value, so as to protect the battery cell well in charging and discharging processes of the battery cell.

As shown in Fig. 4, in which Fig. 4 is a flow chart showing a voltage detecting method according to an exemplary embodiment, the method may be applied in the battery in Fig. 3 and includes following steps.

In step 401, the integrated protection circuit detects a battery voltage over the line resistor with the measuring lines.

With reference to Fig. 3, the measuring terminals of the integrated protection circuit are connected with the terminals of the line resistor by the measuring lines, and the integrated protection circuit is a hardware circuit and can measure a voltage over the line resistor in real time so as to obtain a battery voltage.

In step 402, it is determined whether the battery voltage is within a predetermined voltage range.

In the embodiment, an operation state of the battery mainly includes a charging state and a discharging state, and thus the predetermined voltage range may be defined by a highest voltage in the charging state and a lowest voltage in the discharging state.

In step 403, the integrated protection circuit is disconnected from the metal-oxide-semiconductor field-effect transistor by the on-off control line if the battery voltage is outside the predetermined voltage range.

When the battery voltage is within the predetermined voltage range, the battery can charge and discharge freely and the integrated protection circuit controls the MOSFET to be on via the on-off control line.

When the battery voltage is outside the predetermined voltage range, for an over charging state in which the battery voltage is larger than the highest voltage, the integrated protection circuit controls the MOSFET to be off via the on-off control line so as to stop charging the battery cell; for an over discharging state in which the battery voltage is less than the lowest voltage, the integrated protection circuit controls the MOSFET to be off via the on-off control line so as to stop the battery cell discharging to a load.

It can be seen from above embodiments, with the voltage detection method provided by the embodiment, by measuring the line resistor in the circuit line with the integrated protection circuit, an accurate voltage value can be obtained, and the on-off of the MOSFET can be controlled according to the voltage value so as to protect the battery cell well in the charging and discharging processes of the battery cell.

Other embodiments of the invention will be apparent to those skilled in the art from consideration of the specification and practice of the invention disclosed here. This application is intended to cover any variations, uses, or adaptations of the invention following the general principles thereof and including such departures from the present invention as come within known or customary practice in the art.

## Claims

1. A voltage detection apparatus, comprising: a voltage detection module (110) and a circuit line (120); wherein, a segment of the circuit line is configured as a line resistor (121), and detecting terminals (111) of the voltage detection module are connected to terminals of the line resistor via measuring lines (112) respectively.

2. The apparatus according to claim 1, wherein the voltage detection module comprises: an integrated protection circuit (210), or a voltammeter.

3. The apparatus according to claim 2, wherein if the voltage detection module comprises the integrated protection circuit (210), the voltage detection apparatus further comprises an on-off control line (220) and a metal-oxide-semiconductor field-effect transistor (230), and the integrated protection circuit is connected with the metal-oxide-semiconductor field-effect transistor via the on-off control line; and
a first terminal of the circuit line is connected with the metal-oxide-semiconductor field-effect transistor and a second terminal of the circuit line is connected with a battery cell.

4. The apparatus according to claim 3, wherein if the integrated protection circuit detects that a voltage over the line resistor is outside a predetermined voltage range, the integrated protection circuit is disconnected from the metal-oxide-semiconductor field-effect transistor (230) via the on-off control line (220).

5. The apparatus according to any one of claims 1-4, wherein a length of the line resistor satisfies a formula of

$$L=\frac{R\times S}{\rho},$$

where, L represents the length of the line resistor (121), R represents a resistance of the line resistor, S represents a sectional area of the line resistor, and p represents a resistivity of the line resistor.

6. The apparatus according to any one of claims 1-5, wherein a predetermined resistance of the line resistor (121) is 10 milliohms.

7. A battery, comprising: a power source protection circuit (310) and a battery cell (320); wherein, the power source protection circuit comprises an integrated protection circuit (311), a metal-oxide-semiconductor field-effect transistor (313) connected with the integrated protection circuit via an on-off control line (312) and a circuit line having a first terminal connected with the metal-oxide-semiconductor field-effect transistor and a second terminal connected with the battery cell; wherein, a segment of the circuit line (314) is configured as a line resistor (3141), and detecting terminals of the integrated protection circuit are connected to terminals of the line resistor via measuring lines respectively.

8. The battery according to claim 7, wherein a length of the line resistor satisfies a formula of

$$L=\frac{R\times S}{\rho},$$

where, L represents the length of the line resistor, R represents a resistance of the line resistor, S represents a sectional area of the line resistor, and p represents a resistivity of the line resistor.

9. The battery according to claim 7 or 8, wherein a predetermined resistance of the line resistor is 10 milliohms.

10. A voltage detection method, applied in a battery according to any one of claims 7-9 and comprising:

   detecting (401) by the integrated protection circuit a battery voltage over the line resistor with the measuring lines;
   determining (402) whether the battery voltage is within a predetermined voltage range;
   disconnecting (403) the integrated protection circuit from the metal-oxide-semiconductor field-effect transistor by the on-off control line if the battery voltage is outside the predetermined voltage range.

11. The method of claim 10, comprising, before said configuring the circuit line (120) as a line resistor, predetermining a length of the line resistor.

12. The method of claim 11, wherein a length of the predetermined line resistor satisfies a formula of

$$L = \frac{R \times S}{\rho},$$

where, L represents the length of the line resistor, R represents a resistance of the line resistor, S represents a sectional area of the line resistor, and p represents a resistivity of the line resistor.

13. The method of claim 12, wherein the predetermined length is theoretical, the method comprising correcting an actual length of the line resistor based on the theoretical length.

110

111

voltage detection
module

detecting
terminal

detecting
terminal

112

120

line resistor

121

Fig. 1

210

integrated protection circuit

212

220

211

241

230

line resistor

240

MOSFET

Fig. 2

battery

power source protection circuit

320

310

311

battery cell

integrated protection circuit

3112

312

3111

3141

313

MOSFET

line resistor

314

Fig. 3

| | |
|---|---|
| The integrated protection circuit detects a battery voltage over the line resistor with the measuring lines | 401 |
| It is determined whether the battery voltage is within a predetermined voltage range | 402 |
| The integrated protection circuit is disconnected from the metal-oxide-semiconductor field-effect transistor by the on-off control line if the battery voltage is without the predetermined voltage range | 403 |

Fig. 4